# EUROPEAN PATENT SPECIFICATION

(11) **EP 2 960 915 B1**
(45) Date of publication and mention of the grant of the patent: **10.05.2017**
(21) Application number: 14173925.0
(22) Date of filing: 25.06.2014
(51) Int. Cl.: H01H 9/04, H01H 35/34, H01H 85/00, G01D 11/24, E21B 33/03, H01L 23/051, H05K 7/14

(54) **Housing of electrical components**
Gehäuse elektrischer Komponenten
Boîtier de composants électriques

(43) Date of publication of application: 30.12.2015
(73) Proprietor: ABB Schweiz AG, 5400 Baden (CH)
(72) Inventor: Bessire, Cedric, CH-4500 Solothurn (CH); Duran, Hamit, CH-5300 Turgi (CH); Spindler, Christian, CH-8707 Uetikon am See (CH); Schuderer, Juergen, CH-8047 Zürich (CH); Lendenmann, Heinz, SE-722 18 Västerås (SE); Duarte, Liliana, CH-8152 Opfikon (CH)
(74) Representative: Savela, Reino Aleksi

(56) References cited:
- EP-A1- 2 495 746
- EP-A1- 2 565 899
- EP-A1- 2 570 585
- EP-A1- 2 717 401
- WO-A1-2011/071475
- WO-A1-2012/006735
- US-B1- 6 568 266

## Description

### TECHNICAL FIELD

Embodiments presented herein relate to housing of electrical components, and particularly to an arrangement for pressure tolerant housing of an electrical component.

### BACKGROUND

Packaging is essential for electrical components such as semiconductors in order to connect them electrically and protect them from environmental influence. This is in particular the case for power semiconductors that are employed as main switching elements in various applications such as frequency converters which are used to drive motors in pumps, compressors etc.

Frequency converters in the medium voltage and high power range drive electric motors by controlling the speed and torque of these machines and are a well proven equipment in the entire onshore as well as offshore platform based industry. In recent years, growing interest has been laid on installing electrical installations on the sea floor in depths from a few tens of meters to even kilometers. One main driver of this development is the oil and gas industry, but future applications are seen in subsea high-voltage, direct current or high voltage alternating current transmission and distribution systems as well as offshore power generation (such as wind energy, tidal energy, wave energy, ocean current energy).

Subsea oil and gas production employs electric equipment such as drilling motors, pumps, and compressors that are currently driven by frequency converters located on topside platforms. Electric power is provided to the subsea machinery by expensive umbilical cables. By installing frequency converters and other power electronic equipment (such as insulated-gate bipolar transistor (IGBT) power semiconductor elements) subsea, cables and topside installations could be spared and significant cost savings could be achieved.

In general terms, electric subsea installations and devices usually demand high standards regarding durability, long-term functionality and independence during operation.

Thus, whilst currently the semiconductor module housing for the power electronic equipment is open to air, for applications in a liquefied and pressurized environment (as it is the case in a subsea converter installation at the bottom of the ocean) certain adjustments would be required in order to protect the silicon (Si) chip of the power semiconductor elements. In bringing power electronic equipment to be part of subsea applications, two general concepts currently exist.

According to a first concept the power electronic equipment stays at atmospheric pressure. This is realized in pilot plants today. This first concept allows standard electric/electronic components, known from onshore installations, to be used. However, thick walls are needed for the enclosure to withstand the pressure difference between inside and outside the tank as the tank is submerged into the ocean. Thick walls make the equipment heavy and costly. In addition, heat transfer through thick walls is not very efficient. Additionally, huge and expensive cooling units are required. This concept may thus be regarded as an open solution with a dielectric liquid.

According to a second concept the equipment is passively pressurized to the hydrostatic pressure level of the ambient sea water (increasing by 1 bar each 10 m, typically 100 to 300 bar for subsea installations under consideration). This is achieved by filling a thin-walled vessel with liquid of negligible compressibility. This is still in early development. This second concept does not require any thick walls for enclosure since no pressure difference exists between inside and outside the containment. Cooling is greatly facilitated by thin walls. This requires all the components to be free of gas inclusions and compressible voids. Otherwise they may implode during pressurization and thus be destroyed. Dielectric liquid must be stable over time in order to keep its insulating behavior during the entire time of operation. Further, impurities may evolve over time in the dielectric liquid used within the thin-walled vessel. If this dielectric liquid directly touches the termination on the silicon (Si) chip the impurities risk triggering a high peak field that may destroy the Si chip. This may become a reliability issue that (only) affects the semiconductor modules after some time in operation in a liquid environment. The second concept may thus be regarded as a hermetically closed package solution.

EP 2495746 A1 discloses a subsea fuse assembly adapted to be operated in a pressurized environment comprising an enclosure having an opening sealed by a membrane of a pressure compensator, electric conductors passing into the enclosure, and a fuse electrically connected between the electric conductors. The membrane is compressed between two flanges.

Hence, there is still a need for an improved arrangement for pressure tolerant housing of an electrical component.

### SUMMARY

An object of embodiments herein is to provide an improved arrangement for pressure tolerant housing of an electrical component.

A particular object is to provide an arrangement for subsea housing of electric components combining the advantages of the above presented first concept and second concept whilst still avoiding disadvantages of the above presented first concept and second concept.

According to one aspect there is presented an arrangement for pressure tolerant housing of an electrical component according to independent claim 1.

Advantageously this provides an improved arrangement for pressure tolerant housing of an electrical component.

Advantageously this arrangement combines advantages of the above disclosed first concept and second concept.

Advantageously the disclosed arrangement enables maintaining the advantages of well-known hermetically closed press-pack devices with only small modifications to the housing construction.

Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The inventive concept is now described, by way of example, with reference to the accompanying drawings, in which:
Figure 1 is a schematic diagram illustrating Von-Mises stress and deformation of an upper flange under 50 MPa external hydrostatic pressure;
Figure 2 is a schematic diagram illustrating a cross-sectional view of an arrangement;
Figure 3 is a schematic diagram illustrating a cross-sectional view of an arrangement according to embodiments;
Figure 4 is a schematic diagram illustrating a cross-sectional view of part of an arrangement according to embodiments (no pressure applied);
Figure 5 is a schematic diagram illustrating a cross-sectional view of part of an arrangement according to embodiments when the housing is clamped (no pressure applied);
Figure 6 is a schematic diagram illustrating a cross-sectional view of part of an arrangement according to embodiments when outer pressure is applied;
Figure 7 is a schematic diagram illustrating a cross-sectional view of part of an arrangement according to embodiments;
Figure 8 is a schematic diagram illustrating a step-by-step assembly process of an arrangement according to embodiments;
Figure 9 is a schematic diagram illustrating a three-dimensional presentation of a step-by-step assembly process of an arrangement according to embodiments;
Figure 10 is a schematic diagram illustrating a cross-sectional view of part of an arrangement according to embodiments without a hinge but with a small gap with size d;
Figure 11 is a schematic diagram illustrating a cross-sectional view of part of an arrangement according to embodiments without a hinge and with applied hydrostatic pressure;
Figure 12 is a schematic diagram illustrating a cross-sectional view of part of an arrangement according to embodiments with a simplified geometry used to simulate different gaps;
Figure 13 is a schematic diagram illustrating Von-Mises stress for different flange thickness and gap distances;
Figure 14 is a schematic diagram illustrating Von-Mises stress for adapted housing geometry with a CuNiCo1Si-alloy flange; and
Figure 15 is a schematic diagram illustrating Von-Mises stress for adapted housing geometry with a NiSiFeMn-alloy flange.

### DETAILED DESCRIPTION

The inventive concept will now be described more fully hereinafter with reference to the accompanying drawings, in which certain embodiments of the inventive concept are shown. This inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description. Any step or feature illustrated by dashed lines should be regarded as optional.

The present invention relates to arrangements for pressure tolerant housing of an electrical component.

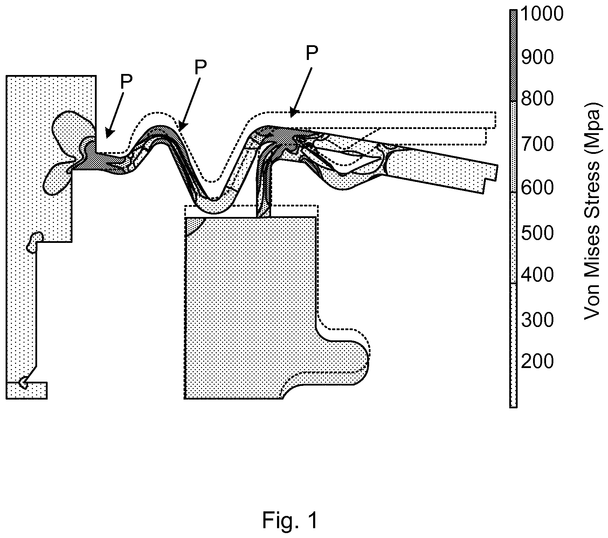

In general terms, the housing (such as a so-called "hockey puck" housing) of bipolar power semiconductor elements is hermetically sealed and thus by design suited for operating in a liquid environment. However, the housing does not withstand isotropic pressure present at the sea ground. The weak point in the housing is the flange enabling the clamping mechanism of the housing in order to establish a good dry contact. If the pressure outside the housing becomes too high, the flange starts to dent inwards and eventually cracks. This can be seen in the finite element method (FEM) simulation results shown in Figure 1 where the arrows indicate locations where a pressure P has been applied. The simulations have been carried out using COMSOL Multiphysics® software. As can be noted in the figure the yield strength R_{p0.2} = 140 MPa of standard OF-Cu is exceeded at many locations.

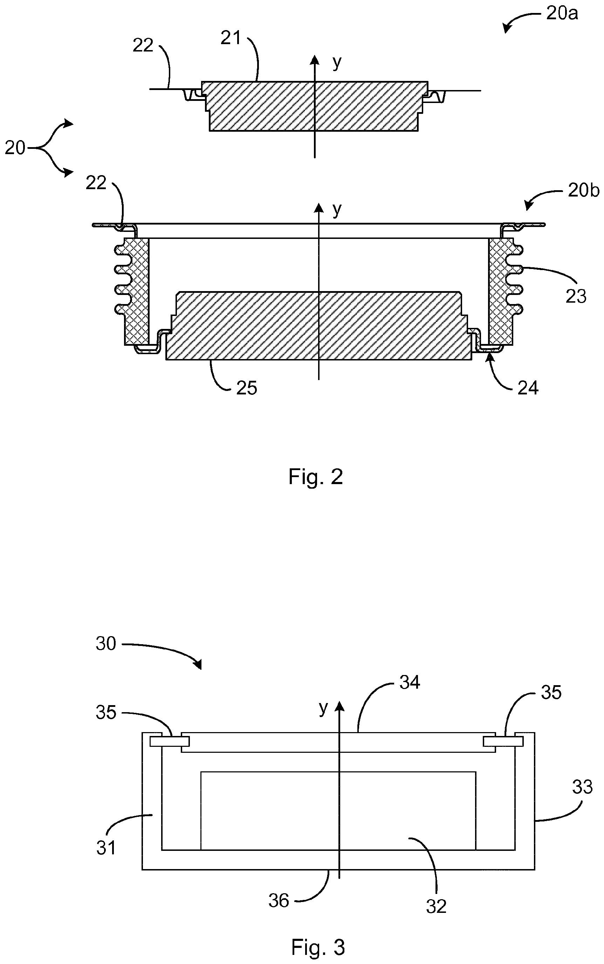

A cross-section drawing of an arrangement 20, 20a, 20b for housing an electrical component in the form of a bipolar diode is shown in Figure 2. The arrangement 20, 20a, 20b comprises an upper part 20a and a bottom part 20b. The upper part 20a comprises a top cover 21. The bottom part 20b comprises a bottom cover 25, a membrane 24, a ceramic ring 23, and a flange 22b. As can be seen in the upper part of the figure, the top cover 21 has a flange 22a with some flexible structure which allows the top cover 21 to move in vertical direction (i.e., along the y-axis) if needed. Typical thickness of the flange 22a is 0.5 mm. Simulations have shown that the flanges 22a, 22b are bent when exposed to 300 bars and more outer pressure, and can eventually break.

A first possible solution to this issue could be to open the housing, thereby allowing dielectric liquid to fill the internal of the housing in order to compensate for the elevated environmental pressure. However, this will cause the hermeticity to be lost, which is in view of the very sensitive edge termination of bipolar power semiconductor devices a significant drawback. In particular, prevention of cross-contamination could be a serious issue to deal with.

A second possible solution could be to make the housing pressure-tolerant by design. Simulations have shown that a flange thickness of 2.5 mm or more is needed to withstand the pressure in a reliable way. However, this has the drawback that the housing loses its mechanical flexibility which may be needed to compensate for dimensional tolerances during clamping of the housing in a stack of housings. In turn, this may pose high demands on the mechanical design and tolerances which could make the housing expensive.

An object of the present invention is to provide an arrangement for pressure tolerant housing of an electrical component which can withstand higher outer pressure than currently available arrangements for housing an electrical component.

Figure 3 schematically illustrates one embodiment of an arrangement 30 for pressure tolerant housing of an electrical component. The arrangement 30 comprises a housing 31. The arrangement 30 further comprises an electrical component 32. The electrical component 32 is enclosed by the housing 31. The housing 31 comprises at least one wall part 33, a bottom part 36, and a top cover part 34. The housing 31 further comprises a joining member 35. The joining member 35 is arranged to join the top cover part 34 to the at least one wall part 33 such that the joining member 35 enables relative movement between the at least one wall part 33 and the top cover part 34 upon a relative pressure P (not shown in Figure 3) being applied to the top cover part 34 and the bottom part 36.

Further embodiments of the disclosed arrangement 30 will now be disclosed.

The housing 31 may be hermetically closed. For example, the housing 31 may be a hermetic and pressure- and liquid-tolerant (hockey puck-like) press-pack.

There are different types of joining members 35 that can be arranged to join the top cover part 34 to the at least one wall part 33. For example, the joining member 35 may be a hinge 35a. For example, the joining member 35 may be a flange 35b. Hence, the housing 31 may have a flange structure with only sealing part (top flange 35b). This may enable easy assembly of the hinge 35a structure by means two-piece flange (top and bottom). For example, the flange 35b may thus be arranged to hermetically close the housing 31. The joining member 35 may comprise both a hinge 35a and a flange 35b. Hence, the housing 31 may have a flange structure with separate moving part (hinge 35a) and sealing part (top flange 35b). The housing 31 may comprise a single joining member 35 or a plurality of joining members 35. The plurality of joining members 35may be interconnected by a flexible structure. For example, the joining member 35 may comprise a plurality of hinges 35a and a single flange 35b. Hence the hinges 35a can be individual or interconnected with a flexible structure.

There are different materials that are suitable for the joining member 35. For example, the joining member 35 may be made from copper or steel.

The housing 31 may take different shapes. For example, the top cover part 34 may have a circular shape. For example, the bottom part 36 may have a circular shape. For example, the housing 31 may have a circular symmetric shape in view of a longitudinal axis (y-axis) of the housing 31. For example, the at least one wall part 33 may have a metal part 33a and a ceramic part 33b. The ceramic part may be a ceramic ring.

There are different types of electrical components 32 that could be comprised in the housing 31. For example, the electrical component 32 may comprise a silicon wafer. Further, the bottom part 36 and the top cover part 34 are made from a metal and act as electrical poles for the electrical component 32.

Further aspects of the disclosed arrangement will now be disclosed.

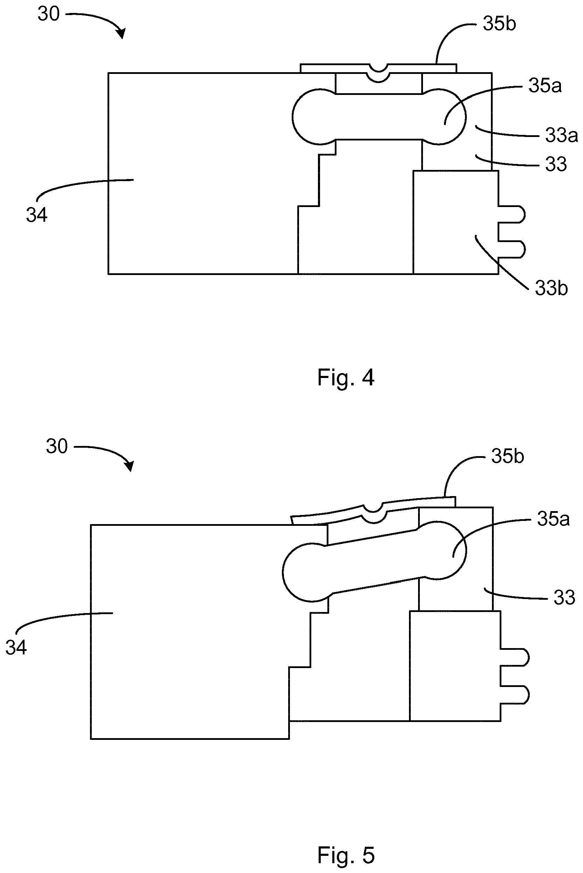

In general terms, a hinge 35a is mechanically strong enough to sustain the relative pressure but also ensures flexibility. Since it may be challenging to fabricate a hinge 35a which is hermetically sealed, explicit hermeticity may be provided by the joining member 35 forming an additional lid in the form of a flange 35b, as shown in Figure 4. Figure 4 shows the pressure-less case where no pressure is applied to the housing 31 and hence all parts of the housing 31 are in their default positions.

In all the following figures only the top parts of the housing 31 are shown. The bottom part 36, the electrical component 32 and the bottom part of a ceramic ring on which the electrical component 32 is provided are not shown.

As noted above, the the bottom part 36 and the top cover part 34 are made from a metal and act as electrical poles for the electrical component 32. Therefore, as soon as the arrangement is clamped into a stack, the top cover part 34 will eventually move in vertical direction in order to make sure that a good electrical contact to the silicon wafer is established. This situation is shown in Figure 5.

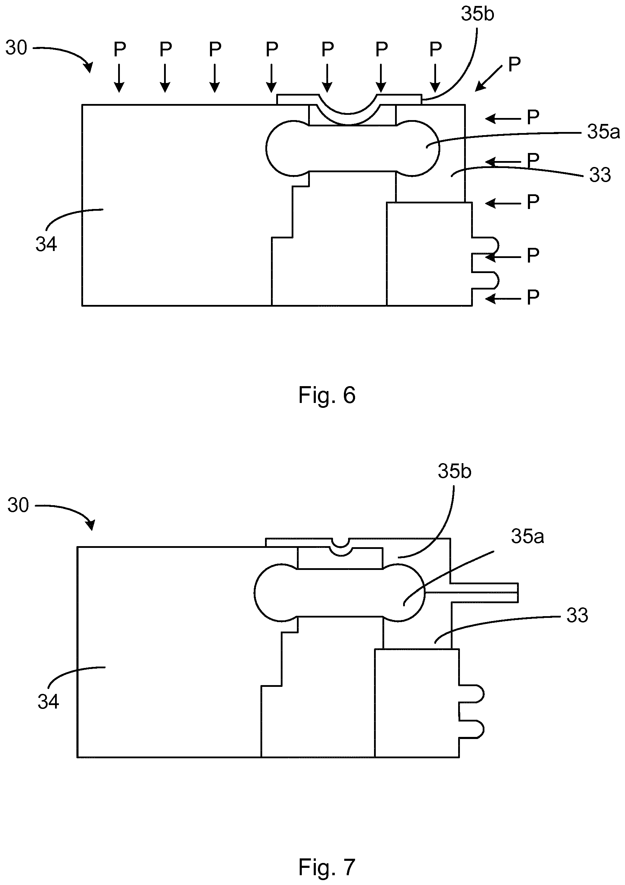

If pressure (P) is applied from the outside, the top cover part 34 will be bent towards the inner side of the housing 31. However, this will come to an end when the lid touches the joining member 35, which is strong enough to sustain the pressure as shown in Figure 6 (where the joining member 35 is provided as a flange 35b and a hinge 35a). In order to make this work, the hinge 35a may be made of copper or a hard material such as steel etc. As can be seen in Figure 7 the side wall 33 of the housing 31 may be divided into two parts and the top part may be combined with the flange 35b.

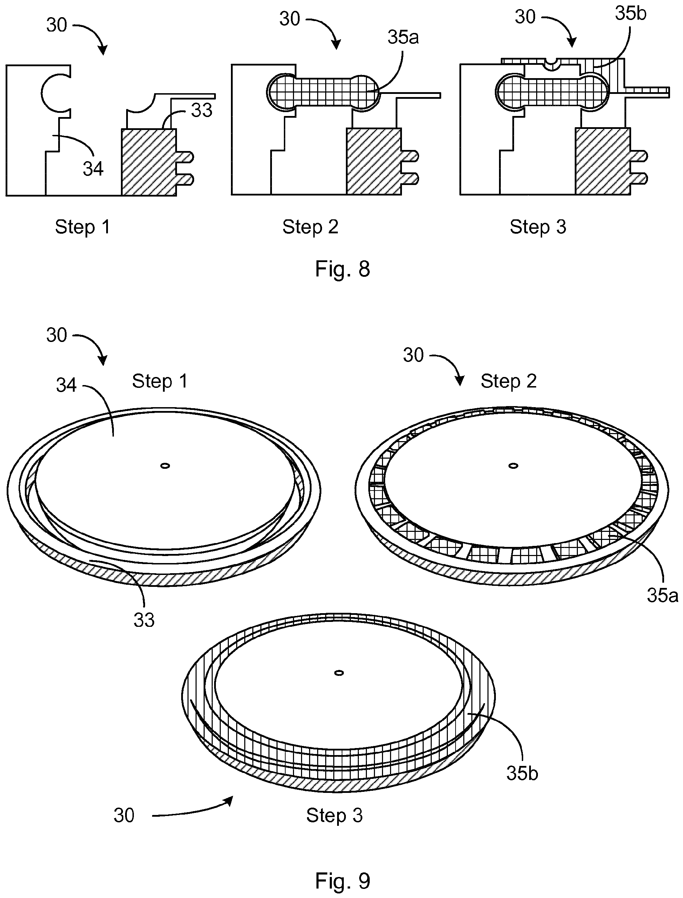

Figure 8 outlines an assembly process of the arrangement 30 by means of a sequence of cross-sectional illustrations of an arrangement. In a first step (step 1; left-most part of Figure 8), the pole piece is placed using a suitable alignment fixture. Then, the hinge 35a is placed as shown in the middle part of Figure 8 (step 2). Finally (step 3; right-most part of Figure 8) the top part of the flange 35b is placed and connected to the pole piece and the bottom part of the flange 35b by means of cold welding or plasma welding. A single welding step can be applied. A corresponding perspective view of the assembly process of the arrangement 30 is given in Figure 9.

As noted above, the housing 31 may comprise a plurality of joining members 35. The joining member 35 may thus comprise a number of individual hinges 35a which may be distributed equally around the top cover part 34. These can be individual hinges 35a, or hinges 35a which are interconnected by a flexible structure. The exact size of, and the distance between, the hinges 35a can be adjusted according to the needs of the application.

In general terms, the concept of having joining members 35 in the form of hinges 35a and flanges 35b as described above is deduced from the idea to separate the package functionality of pressure and liquid protection from each other. In general terms, the hinge 35a provides pressure protection while the flange 35b ensures liquid tightness. Moreover, this concept still allows the upper pole piece (i.e., the top cover part 34) to move in order to clamp the electrical component 32 (such as a silicon wafer) in between the upper and the bottom pole pieces. (i.e., between the top cover part 34 and the bottom part 36). The bottom part 36 may be firmly attached to a ceramic ring with an extended metal structure. Thus no flexibility may be granted between the ceramic ring and the bottom part 36. However, in this way the hermeticity is ensured and the clamping of the electrical component 32 can nonetheless be performed by the top cover part 34.

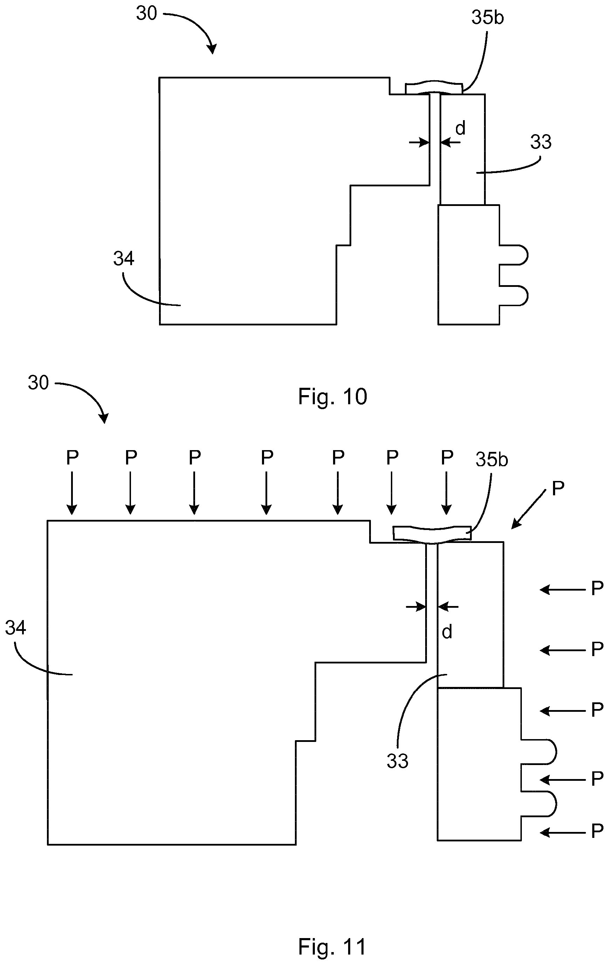

Another way to keep the flexibility of the top cover part 34 and have a hermetic and pressure tolerant arrangement without having a hinge 35a will be described next. The top cover part 34 may be extended and a metal piece forming a flange 35b may be brazed onto the ceramic ring to level the height where the flange 35b is provided between the top cover part 34 and the at least one wall part 33, as illustrated in Figure 10.

The gap (d) between the top cover part 34 and the at least one wall part 33 may be decreased such that only a thin slit remains with a distance d as shown in Figure 10. The flange 35b may be soldered on top of the top cover part 34 and the at least one wall part 33 to hermetically seal the inner part of the housing 31. In this altered packaging concept no hinge 35a is required, since the slit is made as small as possible. Hence the flange 35b becomes pressure tolerant because it is pressed onto the top cover part 34 and the at least one wall part 33 by the outer hydrostatic pressure (P) as indicated in Figure 11. The thickness of the flange 35b and the slit size between the top cover part 34 and the at least one wall part 33 may be determined such that the housing 31 can endure subsea pressure conditions up to a few hundred bars without destroying the top cover part 34.

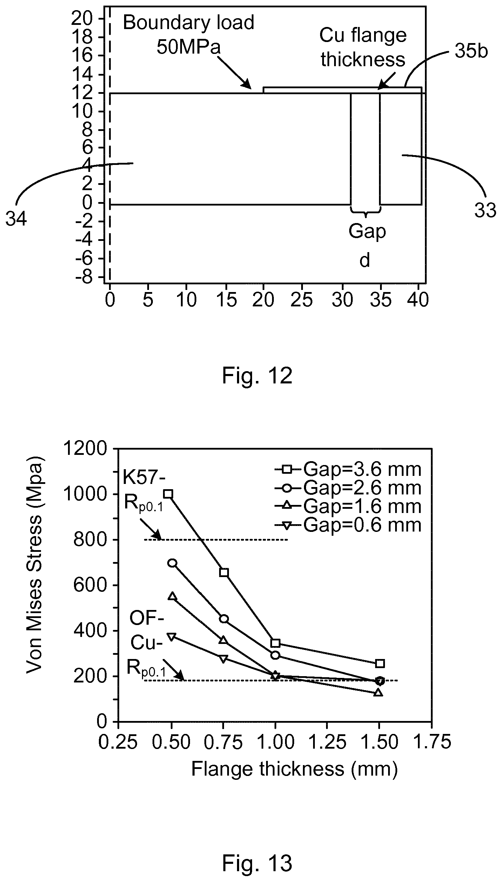

The arrangement shown in Figure 11 was simulated using a FEM simulation software. In order to gain a better understanding a simplified geometry of the arrangement as shown in Figure 12 was used.

The highest von-Mises stress values observed on the top flange 35b were plotted in the graph shown in Figure 13. The graph of Figure 13 shows the von-Mises stress for different flange 35b thicknesses and gap distances. It can be seen that that the flange thickness has a significant impact on the von-Mises stress. The same effect is also observed when the gap is decreased. The simulations were performed with a flange 35b made of copper. However, the trend is true for harder materials as well that might have slightly different absolute stress values. Nevertheless the yield strength of two type of materials which typically may be used, have been considered are standard OF-Cu (yield strength R_{p0.2} = 140 MPa), and copper alloy K57 (CuNiCo1Si with R_{p0.2} = 810 MPa).

From Figure 13 it can be conceived that a K57 structure may be designed such that the yield strength Rp0.2 is not exceeded. At a flange thickness of 0.75mm the hydrostatic pressure of 500 bar (50 MPa) cannot bend such a flange 35b if the gap between the top cover part 34 and the at least one wall part 33 is smaller than 3.6 mm, which is in the range of the state-of-the-art distance between these two elements of the housing 31.

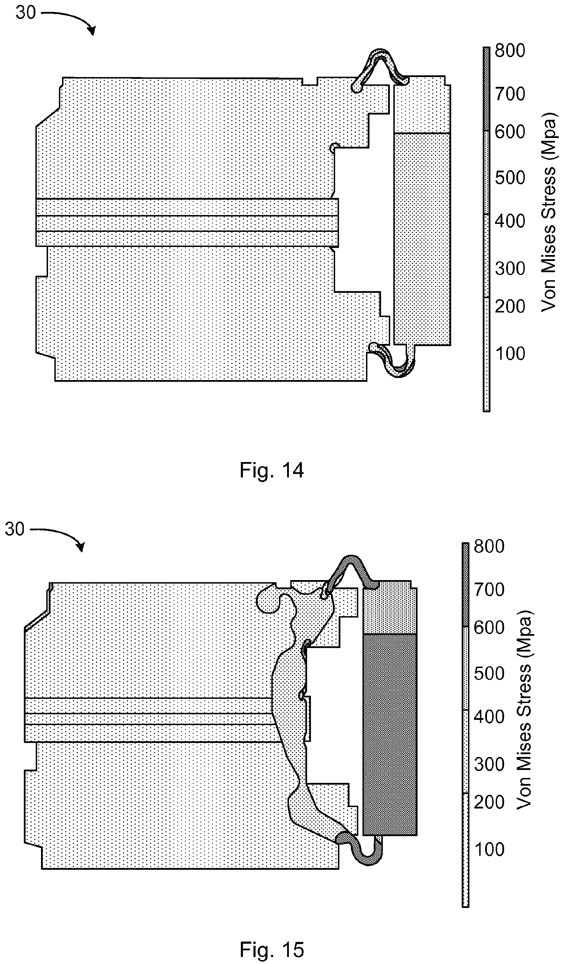

Another geometry was simulated that is close to the proposed geometry of the arrangement in Figure 10 with a gap of only 0.5 mm between the top cover part 34 and the at least one wall part 33. Figure 14 and Figure 15 show the results with a 0.75 mm thick flange 35b made out of CuNiCo1Si and NiSiFeMn (Vacodil), respectively. The colour bar scales with respect to the yield stress of the material (Vacodil: 300 MPa).

Figure 14 shows that only small parts of the flange 35b exceed the yield stress of 810 MPa. Therefore this geometry with a strong K57 copper alloy flange material would be suitable to produce an arrangement for pressure tolerant housing of an electrical component 32. A gap of 0.5mm might be critical because of the thermal expansion of the at least one wall part 33. However, as the graph in Figure 13 indicates, larger gaps above 1mm should be enough, such that K57 withstands the hydrostatic pressure up to 500 bars even though it would be pressed onto the at least one wall part 33.

In Figure 15 the same geometry was simulated with a Vacodil flange (NiSiFeMn-alloy). The von Mises stress is shown with the colour bar that extends to 300 MPa, which is the yield strength of this material. The maximum stress present in the flange 35b by applying 500 bar hydrostatic pressure is around 500MPa. Hence the flange 35b would deform very rapidly towards the at least one wall part 33. From a stability point of view, the K57-alloy shows superior behaviour against hydrostatic pressure.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

## Claims

1. An arrangement (30) for pressure tolerant housing of an electrical component (32), the arrangement comprising:
a housing (31), the housing comprising at least one wall part (33), a bottom part (36), a top cover part (34), and a joining member (35, 35a, 35b); and
an electrical component (32), the electrical component being enclosed by the housing;
wherein the joining member is arranged to join the top cover part to the at least one wall part such that the joining member enables relative movement between the at least one wall part and the top cover part upon a relative pressure (P) being applied to the top cover part and the bottom part; and
wherein the bottom part and the top cover part are made from a metal and act as electrical poles for the electrical component.

2. The arrangement according to claim 1, wherein the housing is hermetically closed.

3. The arrangement according to claim 1 or 2, wherein the joining member is a hinge (35a).

4. The arrangement according to claim 1 or 2, wherein the joining member is a flange (35b).

5. The arrangement according to claim 4, wherein the flange is arranged to hermetically close the housing.

6. The arrangement according to any one of claims 1 to 5, wherein the joining member comprises a hinge (35a) and a flange (35b).

7. The arrangement according to any one of claims 1 to 6, wherein the housing comprises a plurality of joining members.

8. The arrangement according to claim 7, wherein the plurality of joining members are interconnected by a flexible structure.

9. The arrangement according to any one of claims 1 to 8, wherein the joining member comprises a plurality of hinges and a single flange.

10. The arrangement according to any one of claims 1 to 9, wherein said joining member is made from a metal, such as copper or steel.

11. The arrangement according to any one of claims 1 to 10, wherein the top cover part has a circular shape.

12. The arrangement according to any one of claims 1 to 11, wherein the bottom part has a circular shape.

13. The arrangement according to any one of claims 1 to 12, wherein the housing has a circular symmetric shape in view of a longitudinal axis (y) of the housing.

14. The arrangement according to any one of claims 1 to 13, wherein the electrical component comprises a silicon wafer.

## Patentansprüche

1. Anordnung (30) für ein drucktolerantes Gehäuse einer elektrischen Komponente (32), wobei die Anordnung Folgendes umfasst:
ein Gehäuse (31), wobei das Gehäuse mindestens einen Wandteil (33), einen Bodenteil (36), einen oberen Abdeckungsteil (34) und ein Verbindungselement (35, 35a, 35b) aufweist; und
eine elektrische Komponente (32), wobei die elektrische Komponente durch das Gehäuse eingeschlossen ist;
wobei das Verbindungselement eingerichtet ist, den oberen Abdeckungsteil mit dem mindestens einen Wandteil so zu verbinden, dass das Verbindungselement eine Relativbewegung zwischen dem mindestens einen Wandteil und dem oberen Abdeckungsteil ermöglicht, wenn ein relativer Druck (P) auf den oberen Abdeckungsteil und den Bodenteil ausgeübt wird; und
wobei der Bodenteil und der obere Abdeckungsteil aus einem Metall bestehen und als elektrische Pole für die elektrische Komponente dienen.

2. Anordnung nach Anspruch 1, wobei das Gehäuse luftdicht verschlossen ist.

3. Anordnung nach Anspruch 1 oder 2, wobei das Verbindungselement ein Drehgelenk (35a) ist.

4. Anordnung nach Anspruch 1 oder 2, wobei das Verbindungselement ein Flansch (35b) ist.

5. Anordnung nach Anspruch 4, wobei der Flansch eingerichtet ist, das Gehäuse luftdicht zu verschließen.

6. Anordnung nach einem der Ansprüche 1 bis 5, wobei das Verbindungselement ein Drehgelenk (35a) und einen Flansch (35b) aufweist.

7. Anordnung nach einem der Ansprüche 1 bis 6, wobei das Gehäuse eine Vielzahl von Verbindungselementen aufweist.

8. Anordnung nach Anspruch 7, wobei die Vielzahl der Verbindungselemente gegenseitig durch eine flexible Struktur verbunden sind.

9. Anordnung nach einem der Ansprüche 1 bis 8, wobei das Verbindungselement eine Vielzahl von Drehgelenken und einen einzelnen Flansch aufweist.

10. Anordnung nach einem der Ansprüche 1 bis 9, wobei das Verbindungselement aus einem Metall wie Kupfer oder Stahl besteht.

11. Anordnung nach einem der Ansprüche 1 bis 10, wobei der obere Abdeckungsteil eine kreisförmige Form aufweist.

12. Anordnung nach einem der Ansprüche 1 bis 11, wobei der Bodenteil eine kreisförmige Form aufweist.

13. Anordnung nach einem der Ansprüche 1 bis 12, wobei das Gehäuse in Richtung einer Längsachse (y) des Gehäuses gesehen eine kreisförmige symmetrische Form aufweist.

14. Anordnung nach einem der Ansprüche 1 bis 13, wobei die elektrische Komponente einen Silizium-Wafer aufweist.

## Revendications

1. Agencement (30) pour boîtier supportant la pression d'un composant électrique (32), l'agencement comprenant :
un boîtier (31), le boîtier comprenant au moins une partie de paroi (33), une partie de fond (36), une partie de couvercle supérieur (34), et un élément de jonction (35, 35a, 35b) ; et
un composant électrique (32), le composant électrique étant enfermé par le boîtier ;
l'élément de jonction étant agencé pour relier la partie de couvercle supérieur à l'au moins une partie de paroi de telle sorte que l'élément de jonction permet un déplacement relatif entre l'au moins une partie de paroi et la partie de couvercle supérieur lorsqu'une pression relative (P) est appliquée à la partie de couvercle supérieur et la partie de fond ; et
la partie de fond et la partie de couvercle supérieur étant constituées d'un métal et agissant comme des pôles électriques pour le composant électrique.

2. Agencement selon la revendication 1, dans lequel le boîtier est fermé hermétiquement.

3. Agencement selon la revendication 1 ou 2, dans lequel l'élément de jonction est une charnière (35a).

4. Agencement selon la revendication 1 ou 2, dans lequel l'élément de jonction est une bride (35b).

5. Agencement selon la revendication 4, dans lequel la bride est agencée pour fermer hermétiquement le boîtier.

6. Agencement selon l'une quelconque des revendications 1 à 5, dans lequel l'élément de jonction comprend une charnière (35a) et une bride (35b).

7. Agencement selon l'une quelconque des revendications 1 à 6, dans lequel le boîtier comprend une pluralité d'éléments de jonction.

8. Agencement selon la revendication 7, dans lequel la pluralité d'éléments de jonction est interconnectée par une structure souple.

9. Agencement selon l'une quelconque des revendications 1 à 8, dans lequel l'élément de jonction comprend une pluralité de charnières et une seule bride.

10. Agencement selon l'une quelconque des revendications 1 à 9, dans lequel ledit élément de jonction est constitué d'un métal tel que le cuivre ou l'acier.

11. Agencement selon l'une quelconque des revendications 1 à 10, dans lequel la partie de couvercle supérieur a une forme circulaire.

12. Agencement selon l'une quelconque des revendications 1 à 11, dans lequel la partie de fond a une forme circulaire.

13. Agencement selon l'une quelconque des revendications 1 à 12, dans lequel le boîtier a une forme circulaire symétrique dans une vue le long d'un axe longitudinal (y) du boîtier.

14. Agencement selon l'une quelconque des revendications 1 à 13, dans lequel le composant électrique comprend une tranche de silicium.
